# EUROPEAN PATENT APPLICATION

(11) **EP 1 475 669 A1**
(43) Date of publication of application: **10.11.2004**
(21) Application number: 04076238.7
(22) Date of filing: 22.04.2004
(51) Int. Cl.: G03F 7/20

(54) **Lithographic apparatus, device manufacturing method, and device manufactured thereby**

(30) Priority: 06.05.2003 EP 03076395
(71) Applicant: ASML Netherlands B.V., 5504 DR Veldhoven (NL)
(72) Inventor: Dams, Johannes Adrianus Antonius Theodorus, 5509 KD Veldhoven (NL); De Weerdt, Robrecht Emiel Maria Leonia, 2322 Hoogstraten (BE)
(74) Representative: Mertens, Hans Victor

(57) **Abstract**

A lithographic projection apparatus comprising a passive magnetic bearing that provides support between a first and second part of the lithographic apparatus and allows both parts to be displaced relative to each other in a direction perpendicular to the support direction. The passive magnetic bearing comprises a first and second magnet assembly each magnet assembly comprising at least one permanent magnet.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a bearing for supporting a first part of the apparatus with respect to a second part of the apparatus in a first direction such that the first part is movable relative to the second part.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.
Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.
For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Within a lithographic apparatus, bearings are often required between parts of the apparatus that provide support while allowing the parts to move relative to each other. A well known solution for realizing this movable support is an air bearing. The air bearing maintains the parts at a predefined distance by generating the appropriate bearing force. If a linear motor with a ferromagnetic core is used for driving both parts relative to each other, the normal force between the translator and the stator of the motor may be used as a pre-load force for the air bearing. An alternative to the use of an air bearing is to generate the required support by a linear motor or by means of a Lorentz type actuator. A drawback of an air bearing support is that it is difficult to provide such a system under vacuum conditions, a drawback of the linear motor or actuator support is that generation of the required bearing force results in a constant additional heat dissipation in the current carrying components of the linear motor or actuator.

It is an object of the present invention to provide a bearing that may be suitable for use in vacuum and dissipates substantially less heat than a bearing that uses a linear motor or an actuator for providing the bearing force.
This and other objects are achieved according to the invention in a lithographic apparatus as specified in the opening paragraph, characterized in that
- the bearing comprises a passive magnetic bearing.

A bearing force that is substantially provided by a passive magnetic bearing and not by current carrying coils provides a more efficient support compared to linear motor or actuator type bearings yielding a reduced power supply for the apparatus and less heat dissipation inside the apparatus. The latter is a substantial benefit since the thermal stability of a lithographic apparatus is critical.

In an embodiment of the lithographic apparatus according to the present invention, the first part of the lithographic apparatus is supported by the second part in a first direction such that the first part is movable with respect to the second part in a second direction substantially perpendicular to the first direction.

An embodiment of the lithographic apparatus according to the present invention is defined in Claim 3. For this embodiment, a support that has a low stiffness in said support direction is provided by the particular arrangement of the magnet assemblies. A low stiffness bearing has the advantage compared to a higher stiffness bearing that the transmission of vibrations from one part of the bearing to the other is reduced. It should be clear to a person skilled in the art that 'a permanent magnet' should be considered equivalent to an array of individual permanent magnets having the same magnetic polarization placed adjacent to each other.

An embodiment of the lithographic apparatus according to the present invention is defined in Claim 4. This configuration of magnets provides a comparatively large stroke in the second direction along which first and second part can be displaced relative to each other without any substantial variation of the bearing force.

An embodiment of the lithographic apparatus according to the present invention is defined in Claim 5. This particular arrangement also has the benefit of providing a lower stiffness in said first direction.

An embodiment of the lithographic apparatus according to the present invention is defined in Claim 6. This configuration of magnets is such that the bearing has a low stiffness along the first direction and the second direction and a third direction perpendicular to both first and second directions. Low stiffness in three directions enables the control of the magnet bearing (i.e. maintaining a relative position between the first and second parts in said first and third direction) to be executed with minimal effort by, e.g. Lorentz type actuators or linear motors.

An embodiment of the lithographic apparatus according to the present invention is defined in Claim 7. This particular arrangement also has the benefit of providing a low stiffness in all three directions.

An embodiment of the lithographic apparatus according to the present invention is defined in Claim 8. With this embodiment, an increased bearing force can be obtained due to the increased number of magnets, the required bearing force can also be more evenly distributed. Extending the magnet assemblies in said third direction results in a more stable bearing with respect to tilt around said second direction.

An embodiment of the lithographic apparatus according to the present invention is defined in Claim 9. This arrangement results in a more stable bearing with respect to tilt around said third direction because the bearing force is generated as the sum of contributions of the different magnets to this bearing force.

An embodiment of the lithographic apparatus according to the present invention is defined in Claim 10. Making the relative position of at least two or more permanent magnets of at least one of said magnet assemblies adjustable is not only done for allowing a flexible use of the bearing (i.e. for different loads) but can also be used for compensating mechanical or magnetic tolerances of the magnet assemblies. The magnets whose relative position is adjustable can be of equal size or of different size.

An embodiment of the lithographic apparatus according to the present invention is defined in Claim 11. The arrangement of the different magnet assemblies is such that first and second magnet assemblies can rotate relative to each other instead of allowing a linear displacement.

An embodiment of the lithographic apparatus according to the present invention is defined in Claim 12. Making the relative position of at least two or more permanent magnets of at least one of said magnet assemblies adjustable is not only done for allowing a flexible use of the bearing (i.e. for different loads) but can also be used for compensating mechanical or magnetic tolerances of the magnet assemblies. The magnets whose relative position is adjustable can be of equal size or of different size.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.
In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
- Figure 1 schematically depicts a Lithographic projection apparatus;
- Figure 2a schematically depicts a front view of a first embodiment of a passive magnetic bearing according to the present invention for a lithographic apparatus;
- Figure 2b schematically depicts a side view of the first embodiment of figure 2a;
- Figure 2c schematically depicts the magnetic field lines calculated for the passive magnetic bearing as shown in figure 2a.
- Figure 3a schematically depicts a front view of a second embodiment of a passive magnetic bearing according to the present invention for a Lithographic projection apparatus;
- Figure 3b schematically depicts a bottom view of the second embodiment according to figure 3 a;
- Figure 3c schematically depicts the magnetic field lines calculated for the passive magnetic bearing as shown in figure 3a.
- Figure 4a schematically depicts a front view of a third embodiment of a passive magnetic bearing according to the present invention for a Lithographic projection apparatus;
- Figure 4b schematically depicts a bottom view of the third embodiment according to figure 4a;
- Figure 4c schematically depicts the magnetic field lines calculated for the passive magnetic bearing as shown in figure 4a.
- Figure 5a schematically depicts a front view of a fourth embodiment of a passive magnetic bearing according to the present invention for a Lithographic projection apparatus;
- Figure 5b schematically depicts a bottom view of the fourth embodiment according to figure 5a;
- Figure 5c schematically depicts the magnetic field lines calculated for a part of the passive magnetic bearing as shown in figure 5a;
- Figure 5d schematically depicts a possible way of connecting the object table to the fourth embodiment according to the present invention;
- Figure 6a schematically depicts a front view of a fifth embodiment of a passive magnetic bearing according to the present invention for a Lithographic projection apparatus;
- Figure 6b schematically depicts the magnetic field lines calculated for the passive magnetic bearing as shown in figure 6a.
- Figure 7 schematically depicts a front view of a sixth embodiment of a passive magnetic bearing according to the present invention for a Lithographic projection apparatus;
- Figure 8 schematically depicts a front view of a seventh embodiment of a passive magnetic bearing according to the present invention for a Lithographic projection apparatus;
- Figure 9a schematically depicts a front view of an eight embodiment of a passive magnetic bearing according to the present invention for a Lithographic projection apparatus;
- Figure 9b schematically depicts a top view of the eight embodiment of the passive magnetic bearing according to figure 9a;
- Figure 9c schematically depicts an actuator arrangement provided between both parts of the eight embodiment of the passive magnetic bearing;
- Figure 9d schematically depicts a short stroke actuator system provided between the object table and the passive magnetic bearing;
- Figure 10 schematically depicts a front view of a ninth embodiment of a passive magnetic bearing according to the present invention for a Lithographic projection apparatus;
- Figure 11 schematically depicts a front and top view of a tenth embodiment of a passive magnetic bearing according to the present invention for a Lithographic projection apparatus;

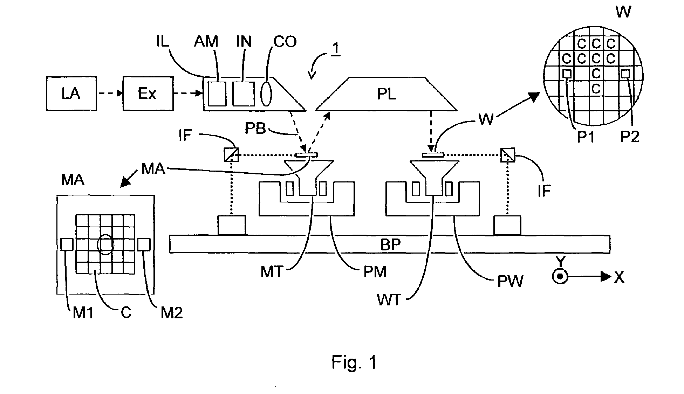

Figure 1 schematically depicts a lithographic projection apparatus 1 according to a particular embodiment of the invention. The apparatus comprises:
- a radiation system Ex, IL, for supplying a projection beam PB of radiation (e.g. UV or EUV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. a refractive or catadioptric system, a mirror group or an array of field deflectors) for imaging an irradiated portion of the mask MA onto a target portion C (e.g. comprising one or more dies) of the substrate W.
As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.
The source LA (e.g. an excimer laser, an undulator or wiggler provided around the path of an electron beam in a storage ring or synchrotron, a laser-produced plasma source, a discharge source or an electron or ion beam source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.
It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.
The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

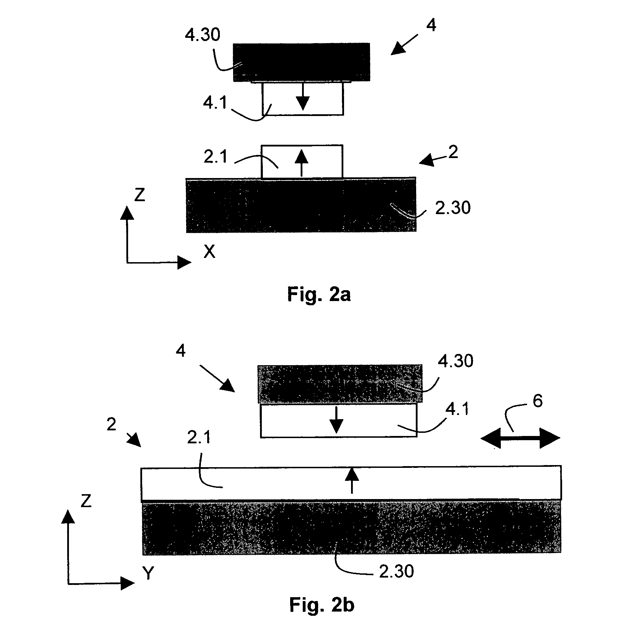

Figures 2a and 2b show a configuration of permanent magnets according to an embodiment of the bearing according to the present invention wherein figure 2a shows a front view and figure 2b shows a side view. In this configuration, the first magnetic assembly 2 comprises a magnet 2.1 arranged on a first part 2.30 of the lithographic apparatus and a second magnet assembly 4 comprising a magnet 4.1 arranged on a second part 4.30 of the lithographic apparatus. The first and second parts can move relative to each other as generally indicated by the arrow 6. This can be done by e.g. an electromagnetic motor positioned between said first and second part.
The arrows inside the magnets 2.1 and 4.1 indicate the magnetic polarization of the magnets. This particular arrangement of magnets produces a repelling magnetic force between said first and second part that is directed in the Z-direction. As can be seen from the side view, both magnet assemblies can be displaced relative to each other in the Y-direction. Because the first magnet assembly is substantially longer in the Y-direction than the second magnet assembly, the magnetic force exerted between both magnet assemblies is substantially independent of the Y-position of the second magnet assembly i.e. a low stiffness in the Y-direction is encountered. The stiffness in the X-direction and the Z-direction however, is rather high in this particular configuration of magnets. Therefore, a significant force variation is encountered when first and second part are displaced relative to each other in the X-direction or in the Z-direction. It should be noted that, in order to maintain the first part 2.30 in the appropriate position relative to the second part 4.30 (e.g. in the Z-direction, the X-direction or both), one or more actuators (such as Lorentz actuators) may be positioned between the parts 2.30 and 4.30. Such actuators may also be provided to prevent the moving part (e.g. part 2.30) from tilting around the X, Y or Z-axis.

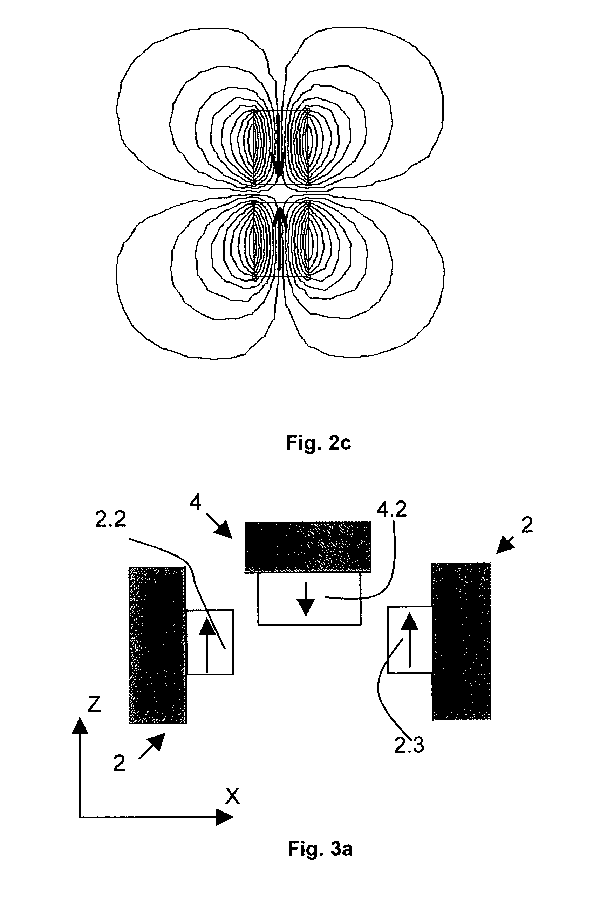

Figure 2c shows the magnetic field lines calculated for this particular arrangement of permanent magnets. As can be seen from figure 2c, each of the magnetic field lines remains within one of the magnet assemblies, non of the field lines connects one of the magnets of the first assembly with one of the magnets of the second assembly.

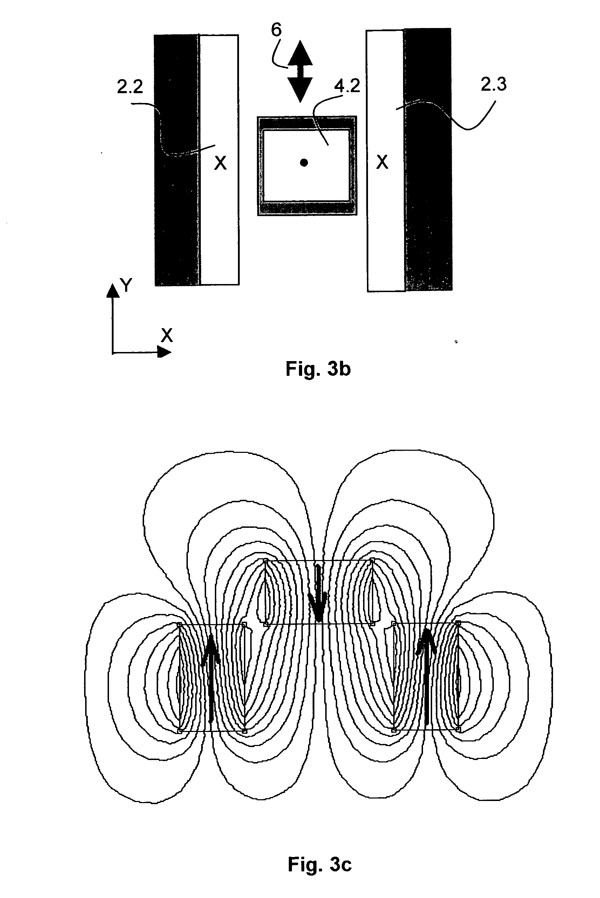

Figures 3a and 3b show an other configuration of permanent magnets according to an embodiment of the present invention wherein figure 3a shows a front view and figure 3b shows a bottom view. In this configuration, the first magnetic assembly 2 comprises two magnets 2.2, 2.3 arranged on a first part of the lithographic apparatus and a second magnet assembly comprising one magnet 4.2 arranged on a second part of the lithographic apparatus. The first and second parts can move relative to each other as generally indicated by the arrow 6. In this arrangement, a lower stiffness is obtained in the Z-direction compared to the configuration shown in figure 2. This lower stiffness is obtained by arranging both magnet assemblies in such a way that a repelling force is generated between both assemblies wherein, different from the situation depicted in figure 2c, a substantial part of the magnetic field lines of both assemblies connect both magnets 2.2 and 2.3 of the first assembly 2 with magnet 4.2 of the second assembly 4. This situation is depicted in Figure 3c showing the magnetic field lines calculated for the configuration shown in figure 3a. This is supported by extensive simulations showing that a low stiffness in the support direction can be obtained by the following measures:
- The magnet assemblies are arranged to repel from each other in the support direction.
- A substantial portion of the magnetic field lines connects a magnet from the first assembly with a magnet from the second assembly.
At least 20% of the magnetic field lines should connect a magnet from the first assembly with a magnet from the second assembly to obtain a comparatively small operating area wherein a low stiffness is encountered. For practical embodiments, it is advised that at least 50% of the magnetic field lines should connect a magnet from the first assembly with a magnet from the second assembly to obtain an increased operating area wherein a low stiffness is encountered. An increased percentage of magnetic field lines connecting a magnet from the first assembly with a magnet of the second assembly results in an increased reduction of the stiffness of the bearing. Also in this embodiment, the first part can be maintained in the appropriate position relative to the second part by applying one or more actuators (such as Lorentz actuators) between both parts. As an alternative, the electromagnetic motor for displacing the first part relative to the second part in the Y-direction, may also be equipped to generate a force between both parts in one or more additional degrees of freedom, i.e. apart from the force generated in the Y-direction. As an example, the electromagnetic motor may be a planar motor capable of displacing both parts relative to each other in all six degrees of freedom. In such an arrangement, the planar motor may drive both parts relative to each other in the Y-direction while maintaining both parts in a predefined position relative to each other in the other five degrees of freedom. Combining the passive magnetic bearing with a planar motor will result in an improved efficiency of the planar motor since the weight of the moving part is compensated by the permanent magnet bearing.

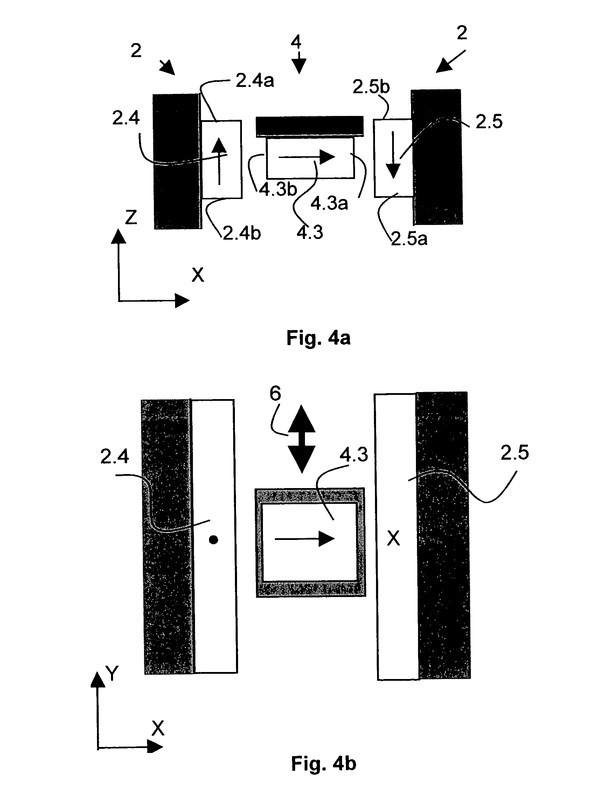

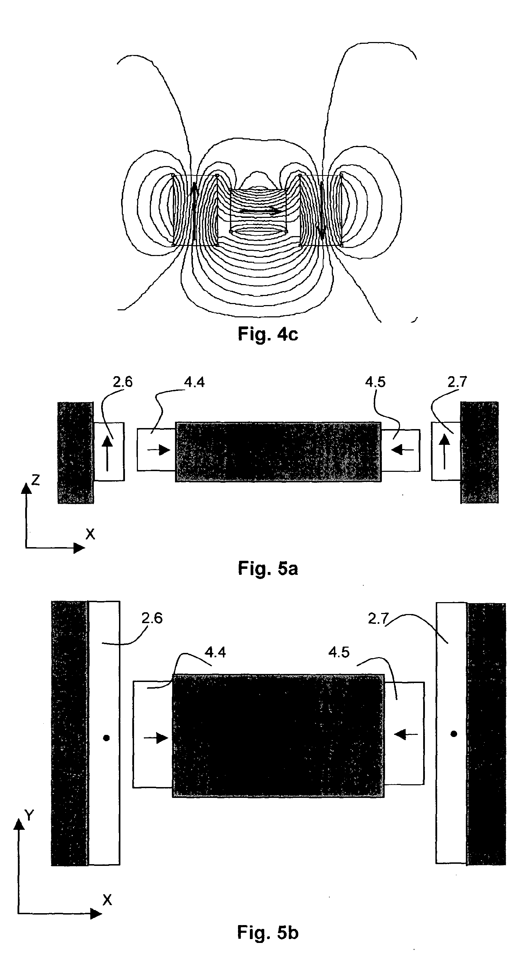

Figures 4a and 4b show an other configuration of permanent magnets according to an embodiment of the present invention wherein figure 4a shows a front view and figure 4b shows a bottom view. In this configuration, the first magnetic assembly 2 comprises two magnets 2.4, 2.5 arranged on a first part of the lithographic apparatus and a second magnet assembly comprising one magnet 4.3 arranged on a second part of the lithographic apparatus. The first and second parts can move relative to each other as generally indicated by the arrow 6. In this arrangement, the stiffness obtained in the Z-direction is even further reduced compared to the configuration shown in figure 2. The bearing force generated between both magnet assemblies is a repelling force in Z-direction. This repelling force can be understood by considering the attraction between poles of different polarity (between 2.4b and 4.3a and between 2.5a and 4.3b) and the repulsion between poles of the same polarity (between 2.4a and 4.3a and between 2.5b and 4.3b). In this situation, when first and second part of the lithographic apparatus are displaced relative to each other in the Z-direction one of said attraction or repulsion will increase while the other will decrease resulting in a comparatively small variation of the resulting force. Figure 4c shows the calculated magnetic field lines for the magnet configuration shown in figure 4a. As is shows in this figure, a substantial portion of the magnetic field lines of this configuration of magnets connects a magnet from the first assembly with a magnet from the second assembly.

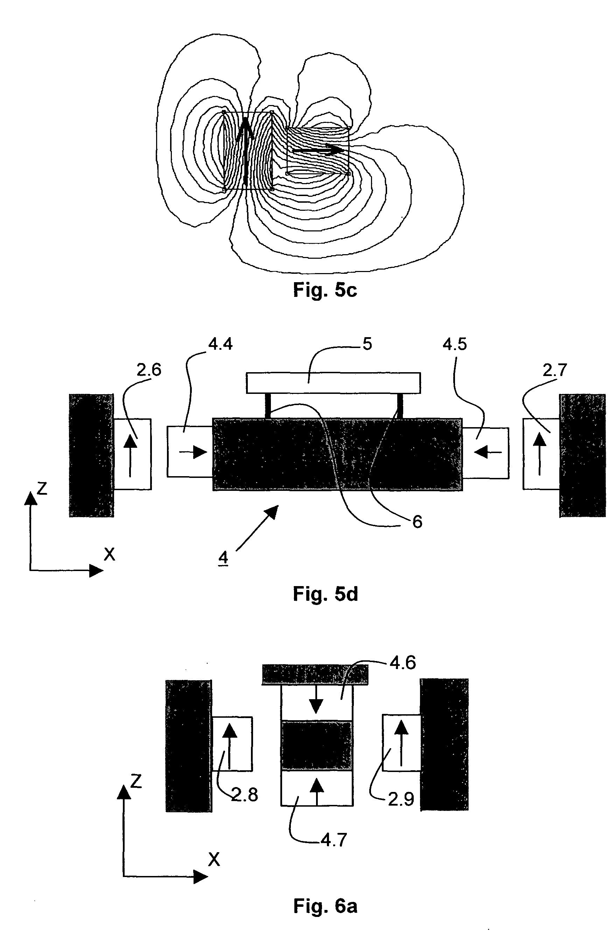

Figures 5a and 5b show another configuration of permanent magnets according to an embodiment of the present invention. Figure 5a shows a front view, Figure 5b shows a top view of the configuration. In this configuration, the first magnetic assembly comprises two magnets 2.6, 2.7 arranged on a first part of the lithographic apparatus and a second magnet assembly comprising two magnets 4.4, 4.5 arranged on a second part of the lithographic apparatus. Figure 5c shows the calculated magnetic field lines for part of the magnet assemblies of figure 5a (the magnetic field of magnets 2.6 and 4.4 is calculated). Since the magnetic field lines shown in figure 5c connect magnet 2.6 of the first assembly with magnet 4.4 of the second assembly, also in this configuration, a low stiffness between both assemblies is obtained. Figure 5d schematically depicts how an object table 5 (e.g. a mask table) can be connected to the magnet assembly 4 of the bearing arrangement. Such a connection can, as an example, be accomplished by means of leaf springs 6. The object table 5 may also be connected directly to the magnet assembly 4. In order to increase the positioning accuracy of the object table, an actuator system may be provided between the object table 5 and the bearing assembly. Such an actuator system may, as an example, comprise electromagnetic actuators such as Lorentz actuators or reluctance actuators or piezo-electric actuators. Similar arrangements for connecting the object table to the bearing assembly or for positioning the object table can also be made with the bearing arrangements shown in figures 2 to 4 and 6 to 10.

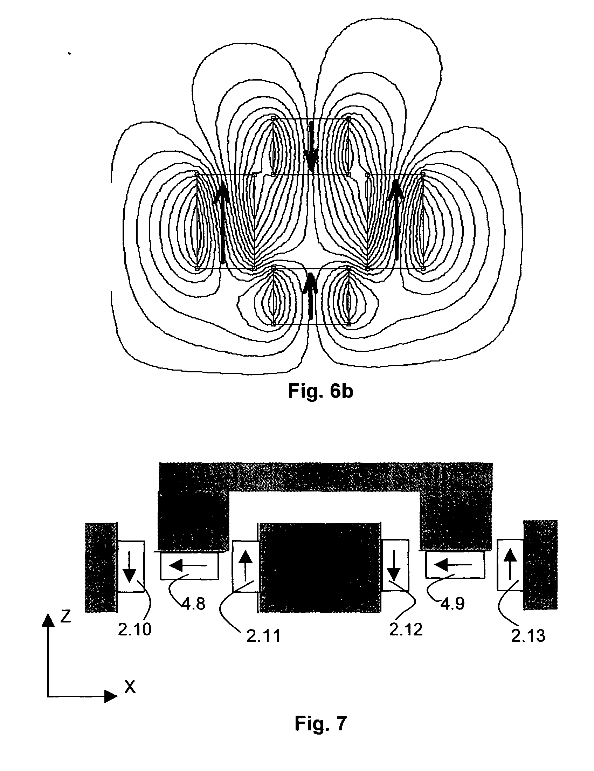

Figures 6a and 6b show a front view of another configuration of permanent magnets according to an embodiment of the present invention. In this configuration, the first magnetic assembly comprises two magnets 2.8, 2.9 arranged on a first part of the lithographic apparatus and a second magnet assembly comprising two magnets 4.6, 4.7 arranged on a second part of the lithographic device. In this particular configuration, all magnets have their magnetization parallel or anti-parallel to each other. Also in this configuration, low stiffness is obtained. As can be seen from figure 6b showing the calculated magnetic field lines, also in this case, a substantial part of the magnetic field lines connects the surface of a magnet from the first assembly with a magnet from the second assembly.

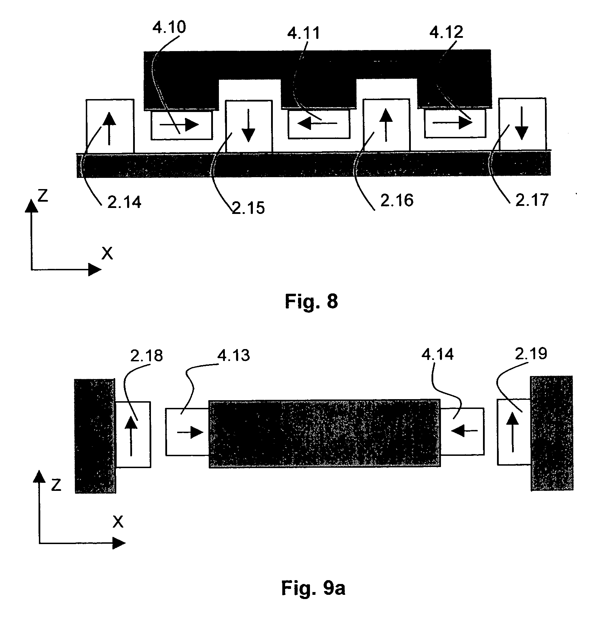

Figure 7 shows another embodiment of the present invention where two magnet configurations according to Figure 3 are combined.

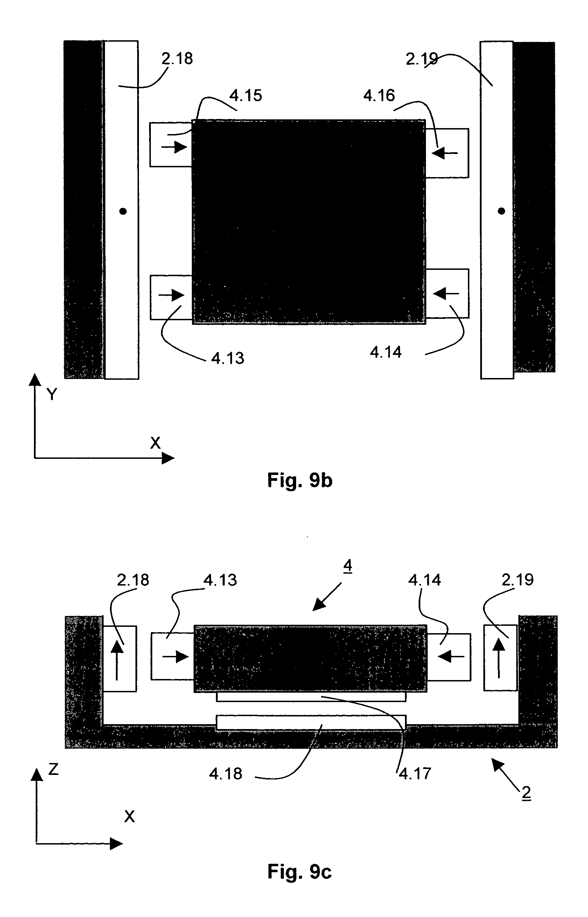

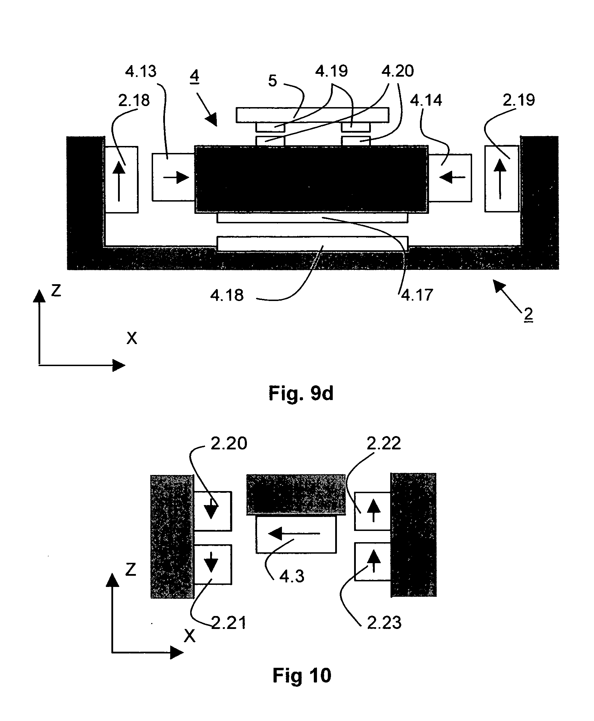

Figure 8 shows another embodiment of the present invention that can be constructed by combining magnet configurations shown in previous embodiments. It is clear to a person skilled in the art that the magnet assemblies as shown can be extended even further in X-direction if required. The magnet assemblies as shown in figures 7 and 8 provide a more stable configuration with respect to tilting around the Y-axis. Combining a plurality of configurations can also be done in Y-direction to obtain an increased bearing force or provide a more evenly distributed bearing force as shown in figures 9a and 9b. Figures 9a and 9b combine two configurations according to figure 4 into one assembly. In this case, the required bearing force is provided as the sum of the force in Z-direction acting on the four magnets 4.13, 4.14, 4.15 and 4.16. This assembly provides a more stable configuration with respect to tilting of the second magnet assembly around the X-axis. In figure 9c, the bearing arrangement is combined with an actuator arrangement. The actuator arrangement is schematically described by elements 4.17 and 4.18. Element 4.17 may, as an example comprise a magnet array that co-operates with a coil assembly 4.18. By means of the actuator arrangement, the magnet assembly 4 may be displaced relative to the magnet assembly 2 in one or more degrees of freedom. In general, the actuator assembly may comprises a linear motor or a planar motor for displacing both assemblies 2 and 4 relative to each other over comparatively large distances and may further comprise electromagnetic actuators such as Lorentz actuators or reluctance actuators for positioning both assemblies relative to each other over comparatively small distances in the other degrees of freedom. Similar actuator arrangements may be combined with the bearing arrangements of figures 2 to 10. The mask table, or in general the object table, that requires accurate positioning may be directly coupled to the magnet assembly 4 or e.g. by means of leaf springs. In case the positioning accuracy of the bearing assembly and actuator assembly is not sufficient, an additional actuator arrangement (a so-called short stroke actuator system) may be applied between the object table and the bearing arrangement. Such an arrangement is schematically depicted in figure 9d. Figure 9d schematically depicts a short stroke actuator system arranged between the object table 5 and the magnet assembly 4 of the magnetic bearing. In such an arrangement, the coarse positioning of the magnet assembly 4 may be provided by the actuator system 4.17, 4.18 while the short stroke actuator system 4.19, 4.20 can be applied for accurate positioning of the object table. The short stroke actuator system may, as an example comprise a plurality of Lorentz actuators, each comprising a magnet system 4.19 and a coil system 4.20.
Figure 10 shows an other embodiment of the present invention wherein the first magnet assembly comprises four magnets 2.20, 2.21, 2.22, and 2.23, the distance in Z-direction between 2.20 and 2.21 and between 2.22 and 2.23 being adjustable in order to adjust the bearing force. The embodiment shown in figure 10 has the same performance with respect to stiffness as the embodiment shown in figure 4. Subdividing each of the magnets 2.4 and 2.5 of the embodiment shown in figure 4 into two magnets with the same polarization and displacing them relative to each other in Z-direction, results in the embodiment shown in figure 10. Subdividing the magnets of one or both of the magnet assemblies in order to make the bearing force adjustable can be applied to all embodiments. In general, if at least one of the magnet assemblies is provided with at least two magnets and means is provided to adjust the distance between those magnets, the bearing force can be adjusted. As an example, the bearing force generated by the embodiment shown in Figure 3 can be adjusted by displacing magnets 2.2 and 2.3 relative to each other in the X-direction. As an other example, the magnets 4.6 and 4.7 in the embodiment shown in Figure 6 can be used for adjusting the bearing force if means is provided for adjusting the distance between both arrays.
For all embodiments shown in Figures 2-10, a similar performance can be obtained when the second magnet assembly is substantially longer than the first magnet assembly in the Y-direction instead of the first magnet assembly being longer than the second.

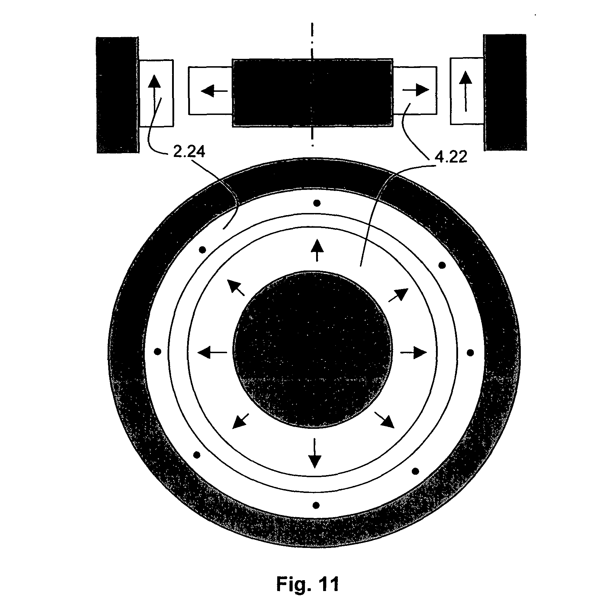

Figure 11 shows another configuration of permanent magnet assemblies according to an embodiment of the invention wherein the magnet assemblies have a substantially circular shape. The upper part of Figure 11 shows a front view, the bottom part shows a top view. In the embodiment shown, the first magnet assembly comprises one magnet 2.24, the second magnet assembly comprises one magnet 4.22. Both circular assembly are arranged to have the same axis of symmetry. This allows both parts of the bearing to rotate relative to each other around said axis of symmetry. In order to maintain the appropriate relative position between both permanent magnet assemblies, the embodiment shown may further be equipped with one or more actuators. Such actuators may comprise rotary electromagnetic motors, piezo-electric motors, linear actuators, etc. It should further be noted that each of the embodiments shown in figures 2 to 10 may be modified in order to provide a passive magnetic bearing for a substantially circular arrangement.

The passive magnetic bearing can be applied to all components of the lithographic apparatus that require a movable support. Some examples are the use of the passive magnetic bearing between a base frame and a dynamic component such as a support structure or substrate table or between a balance mass and a base frame or between a balance mass and a base frame. As an example, the passive magnetic bearing may be applied in a positioning device for positioning a mask table over comparatively large distances relative to a frame in the scanning direction. In such an arrangement, the positioning device may comprise a linear motor, the linear motor operating between the mask table and the frame. In such an arrangement, the passive magnetic bearing may also be applied between the mask table and the frame. In general, the positioning device may further be equipped with actuators (e.g. Lorentz actuators) for maintaining the mask table in the appropriate position relative to the frame. In order to increase the accuracy of the positioning of the mask table, the positioning device may further be equipped with a short stroke actuator system for accurately positioning the mask table relative to e.g. a projection system of the apparatus. The passive magnetic bearing can also be applied for movably supporting optical elements such as lenses or mirrors.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a bearing for supporting a first part of the apparatus with respect to a second part of the apparatus in a first direction such that the first part is movable relative to the second part,
**characterized in that**:
- the bearing comprises a passive magnetic bearing.

2. A lithographic projection apparatus according to claim 1, **characterized in that**, in use, the first part is supported by the second part in a first direction such that the first part is movable with respect to the second part in a second direction substantially perpendicular to the first direction.

3. A lithographic projection apparatus according to claim 2, **characterized in that** said bearing comprises a first and a second magnet assembly, wherein each magnet assembly is provided with a permanent magnet and wherein the magnet assemblies are arranged for mutual cooperation in such a way that in use a repelling force is generated between both assemblies wherein a substantial part of the magnetic field lines of the said magnets of the assemblies connect the magnet of the first assembly with the magnet of the second assembly magnets of different assemblies.

4. A lithographic projection apparatus according to claim 3, **characterized in that** said first magnet assembly is substantially longer than the second magnet assembly in said second direction.

5. A lithographic projection apparatus according to claim 3, **characterized in that** the first magnet assembly comprises a second permanent magnet, wherein said magnets of the first assembly each have their magnetic polarization parallel or anti-parallel to said first direction, and defining a space between them in a third direction perpendicular to said first and second direction, wherein the magnet of the second magnet assembly has its polarization substantially anti-parallel to the polarization of the magnets of the first assembly, said magnet of the second magnet assembly at least partly being located in said space.

6. A lithographic projection apparatus according to claim 3, **characterized in that** the first magnet assembly comprises a second permanent magnet, said magnets of the first magnet assembly having their magnetic polarization parallel or anti-parallel to said first direction, and defining a space between them in a third direction perpendicular to said first and second direction, wherein the magnet of the second magnet assembly has its polarization substantially perpendicular to the polarization of the magnets of the first assembly, said magnet of the second magnet assembly at least partly being located in said space

7. A lithographic projection apparatus according to claim 3, wherein the first magnet assembly also comprises a second permanent magnet, wherein said magnets of the first assembly have their magnetic polarization parallel to each other, and defining a space between them in a third direction perpendicular to said first and second direction, wherein the second magnet assembly comprises a second permanent magnet, one magnet of the second assembly having its polarization substantially parallel to the polarization of the magnets of the first assembly and one magnet of the second assembly having its polarization substantially anti-parallel to the polarization of the magnets of the first assembly, said magnets of the second magnet assembly at least partly being located in said space.

8. A lithographic projection apparatus according to claim 3, wherein the first magnet assembly comprises a plurality of elongated permanent magnets arranged parallel to each other in said second direction, each pair of adjacent magnets defining a space between them in a third direction substantially perpendicular to said first and second direction, wherein the second magnet assembly comprises a second permanent magnet, wherein the said magnets of the second assembly are placed adjacent to each other in said third direction, wherein each magnet at least partly being located in one of said spaces defined by two adjacent magnets of said first assembly and wherein the magnets of said first assembly have their magnetic polarization substantially parallel or anti-parallel to each other, wherein the magnets of said second assembly have their magnetic polarization substantially perpendicular to the magnetic polarization of the magnets of the first assembly.

9. A lithographic projection apparatus according to one of the claims 3 to 8, **characterized in that** the second magnet assembly comprises multiple magnets which are arranged adjacent to each other in said second direction.

10. A lithographic projection apparatus according to one of the claims 3 to 9, **characterized in that** the relative positions of at least two or more permanent magnets of at least one of said magnet assemblies are adjustable.

11. A lithographic projection apparatus according to claim 1, wherein said bearing comprises a first and second magnet assembly, wherein the first magnet assembly comprises at least one permanent magnet and wherein the second magnet assembly comprises at least one permanent magnet and wherein each magnet assembly substantially has a circular shape.

12. A lithographic projection apparatus according to claims 1 and 11, wherein at least one of said magnet assemblies comprises two or more permanent magnets, the relative position of the magnets being adjustable.

13. A lithographic apparatus according to any of the preceding claims further comprising a linear motor constructed and arranged to displace said first part relative to said second part in direction perpendicular to said first direction.

14. A lithographic apparatus according to claim 13 wherein said linear motor comprises a magnet array attached to said second part and a coil unit attached to said first part.

15. A lithographic apparatus according to claims 13 or 14, further comprising a linear actuator constructed and arranged to generate a force between said first part and said second part in said first direction.

16. A lithographic apparatus according to any of the claims 11 to 14, further comprising a plurality of linear actuators constructed and arranged to position said first part relative to said second part in at least one degree of freedom.
